# EUROPEAN PATENT SPECIFICATION

(11) **EP 0 411 530 B1**
(45) Date of publication and mention of the grant of the patent: **08.02.1995**
(21) Application number: 90114580.5
(22) Date of filing: 30.07.1990
(51) Int. Cl.: H01L 31/18

(54) **Patterning a transparent conductor**
Strukturierung einer durchsichtigen Leiterschicht
Structuration d'un conducteur transparent

(30) Priority: 31.07.1989 JP 198747/89
(43) Date of publication of application: 06.02.1991
(73) Proprietor: FUJITSU LIMITED, Kawasaki-shi, Kanagawa 211 (JP)
(72) Inventor: Miyagaki, Shinji, C/o Fujitsu Ltd., Kawasaki-shi, Kanagawa 211 (JP); Ri, Seigen, C/o Fujitsu Ltd., Kawasaki-shi, Kanagawa 211 (JP)
(74) Representative: Sunderland, James Harry

(56) References cited:
- US-A- 3 979 240
- US-A- 4 093 504
- US-A- 4 708 766

## Description

The present invention relates to the patterning of transparent conducting film and particularly to a method of patterning transparent conducting film formed on a substrate including silicon.

For a light detecting part of, for example, an imaging device, an amorphous silicon (a-Si) film suitable for receiving visible light, an amorphous silicon carbide (a-SiC) film, or a multilayered film comprising such films is used. As a transparent conducting film, indium (In) . tin (Sn) . oxide film (ITO film), for example, is used. Fabrication of such films is very important in the fabrication of imaging devices.

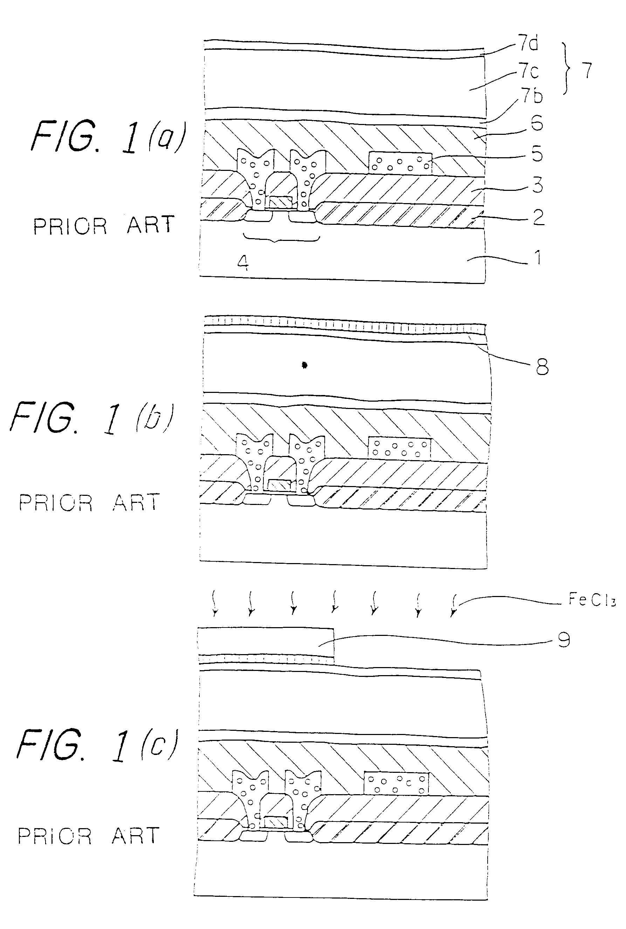

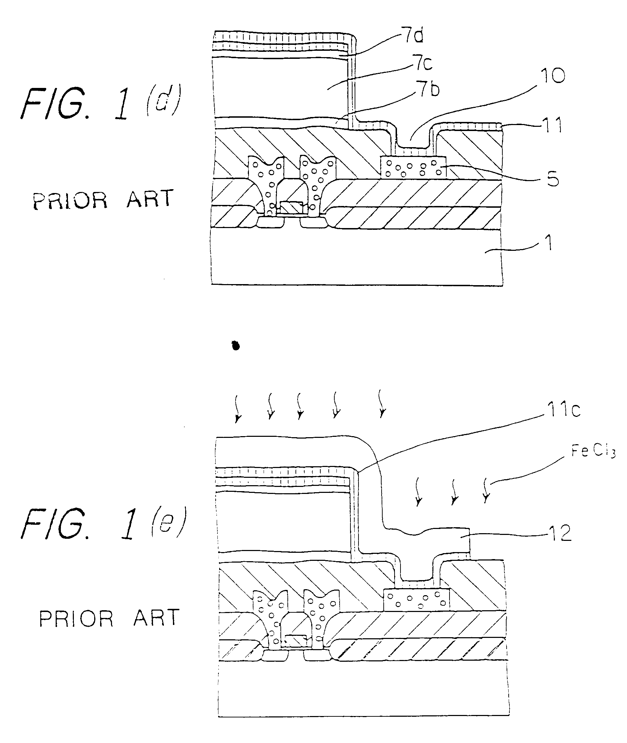

Figs. 1(a) to 1(e) are schematic sectional views for assistance in explaining parts of a conventional fabrication process for producing an imaging device.

Fig. 1(a) shows a sample structure immediately before formation of a transparent conducting film, where a multilayered film consisting of a-SiC film/a-Si film/a-SiC film is formed as a light receiving part. (The structures shown in Figs. 1(a) to (e) are referred to as the "sample" in the following description of fabrication process steps).

In Fig. 1(a), 1 is a silicon substrate; 2 is a silicon oxide film (SiO₂ film) for device separation; 3 is an interlayer insulation film; 4 is a transistor for amplification; 5 is Aℓ wiring; 6 is PSG (phosphosilicate glass) film for flattening; 7 is a light receiving part consisting of a-SiC film 7d/a-Si film 7c/a-SiC film 7b. In this Figure, a collector electrode for charges generated through photoelectric conversion, a charge storage diode and a CCD (charge coupled device) for transferring charges have a well-known structure and are not illustrated.

As illustrated by Fig. 1(b), the sample of Fig. 1(a) is placed into a sputtering apparatus, substrate temperature is raised (up to about 150°C) and thereafter a first transparent conducting film 8 consisting of ITO is formed by sputtering on the a-SiC film 7d. Here, the substrate is heated to improve adhesive strength between the substrate and transparent conducting film and also to improve light receiving characteristics.

Next, as shown in Fig. 1(c), a resist pattern 9 is formed on the first transparent conducting film 8 and this first transparent conducting film 8 is then removed by etching using an aqueous solution of ferric chloride (FeCℓ₃) with the resist pattern 9 used as a mask. Such wet etching is carried out here because, since the vapour pressure of indium (In) and tin (Sn) is low, etching rate is low for dry etching of ITO.

As shown in Fig. 1(d), after the a-SiC film 7d/a-Si film 7c/a-SiC film 7b is etched by nitrogen trifluoride (NF₃), the PSG film 6 on the Aℓ wiring 5 is selectively etched and thereby an aperture 10 is formed. Thereafter, this sample is put into sputtering apparatus and a second transparent conducting film 11 is formed on the sample surface under the same conditions as for formation of the first transparent conducting film 8. Thereby, the Aℓ wiring 5 is connected to the second transparent conducting film 11 through the aperture 10.

Finally, as shown in Fig. 1(e), a resist pattern 12 is formed on the second transparent conducting film 11 and the second transparent conducting film 11 is etched by a FeCℓ₃ aqueous solution with the resist pattern used as mask. As explained above, a leadout electrode 11c is formed, completing an imaging device.

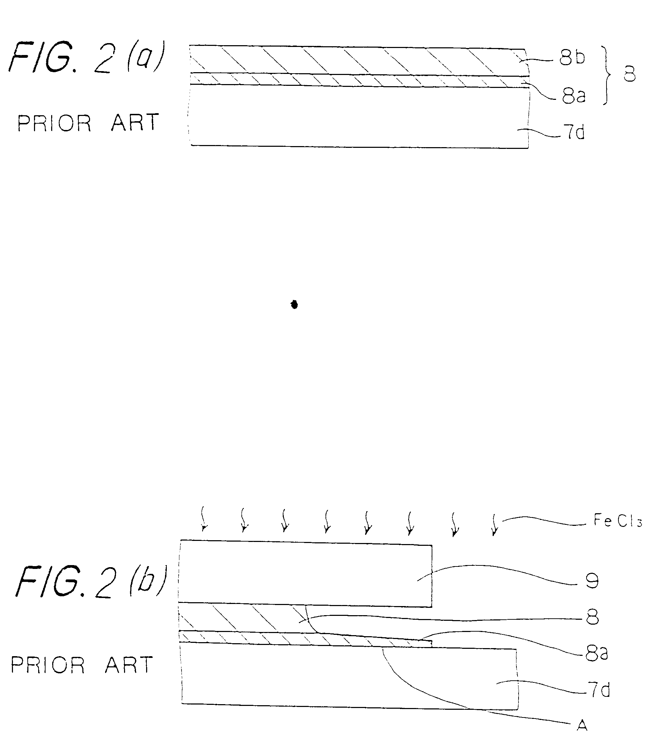

In the above fabrication process, since the sample is kept at about 150°C during formation of the first transparent conducting film 8 of the light receiving part, an interfacial reacted layer 8a is generated by reaction of ITO and Si at the interface between the first transparent conducting film 8 and the a-SiC film 7d, as shown in Fig. 2(a). This interfacial reacted layer 8a does not easily dissolve into the aqueous solution of FeCℓ₃. Therefore, when etching time is set longer in order to ensure complete removal of the interfacial reacted layer 8a shown in Fig. 2(a), lateral etching of the first transparent conducting film 8b, where ITO has not reacted with Si, proceeds as shown in Fig. 2(b), and a part A, where only the interfacial reacted layer 8a remains on the a-SiC film 7d, is generated. When this condition is observed from the direction from which light is incident, the periphery of the first transparent conducting film is partly protruded and recessed. Therefore, protruded and recessed regions are also generated in the periphery of the a-SiC film 7d/a-Si film 7c/a-SiC film 7b by the successive etching. As a result, leakage current of the fabricated imaging device increases.

If, in order to avoid this phenomenon, ITO film is formed at a lower temperature, the ITO film may easily peel off and light transmissivity become small, so that the structure can no longer be put to practical use.

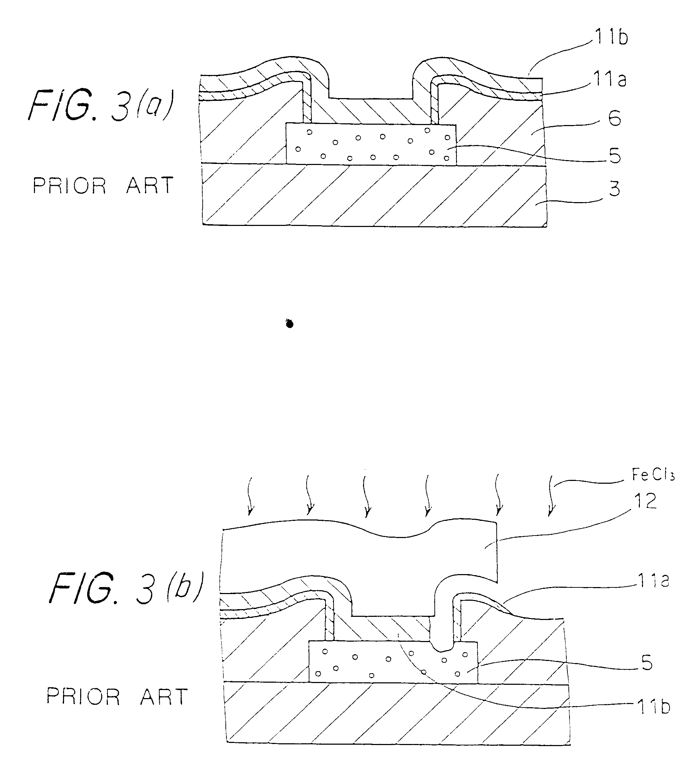

The phenomenon occurring on the first transparent conducting film 8 also occurs in the formation of the second transparent conducting film 11 made of ITO film. Namely, as shown in Fig. 3(a), a side product layer 11a is generated by reaction of ITO and Si included in the PSG film 6 at the interface between the second transparent conducting film 11 and PSG film 6. Therefore, if an attempt is made to completely remove the interfacial reacted layer 11a when the second transparent conducting film 11 is etched, as shown in Fig. 1(e), the ITO film 11b is etched laterally as shown in Fig. 3(b), and the etchant sometimes reaches the Aℓ wiring 5. In this case, the Aℓ wiring 5 may be etched because the etchant includes chlorine. As a result, a problem of deterioration of imaging device quality occurs.

A method of etching transparent conducting film such as ITO, to be used for an imaging device, offering an adequate etching rate and producing no adverse effect on the device characteristics, has not yet been found.

US-A-3 979 240 discloses wet etching of indium tin oxide using a concentrated solution of hydrobromic acid.

US-A-4 708 766 discloses gas and, alternatively, plasma etching of tin oxide.

According to the present invention there is provided a method of forming a patterned transparent conducting film during fabrication of a semiconductor device, comprising the steps of:-
heating a substrate to a temperature of more than 100°C, the substrate including silicon atoms;
forming, whilst maintaining the temperature of the substrate higher than 100°C, a transparent conducting film which includes at least one of indium tin oxide (ITO), aluminium zinc oxide (AZO), tin oxide (SnO₂) indium oxide (In₂O₃), and zinc oxide (ZnO) on the substrate;
patterning a resist film after forming said resist film on said transparent conducting film; and
wet-etching said transparent conducting film using an etchant including a halide, using the patterned resist film as mask, and then dry-etching said transparent conducting film with a reactive gas including a halogen element.

An embodiment of the present invention can provide a method of etching a transparent conducting film, on a substrate including Si, which offers adequate etching rate.

An embodiment of the present invention can provide a method of etching a transparent conducting film, on a substrate including Si, which does not lead to deterioration of device characteristics.

An embodiment of the present invention can provide a method of patterning a transparent conducting film, on a substrate including Si, offering high accuracy.

An embodiment of the present invention may be effected by carrying out etching comprising steps for forming a transparent conducting film such as ITO on a substrate including Si element and executing wet etching of the transparent conducting film with a halide etchant and then dry etching with a reactive gas including a halogen element with a resist pattern formed on the transparent conducting film used as a mask.

When a transparent conducting film, for example indium . tin oxide film (ITO film), aluminium . zinc oxide film (AZO) film, indium oxide film (In₂O₃ film), tin oxide film (SnO₂ film) or zinc oxide film (ZnO film), is grown at a temperature of 100°C or higher, an interfacial reacted layer produced by reaction of ITO, AZO, In₂O₃, SnO₂ or ZnO with Si is formed at the interface between the substrate and transparent conducting film. ITO, AZO, In₂O₃, SnO₂, ZnO films are etched at an adequate etching rate by a halide etchant but the interfacial reacted layer produced by reaction does not easily dissolve into the halide etchant.

However, the inventors have had the insight that since the interfacial reacted layer includes Si, it can be etched at an adequate etching rate by dry etching using reactive gas including a halogen element even though ITO, AZO, In₂O₃, ZnO films have a property of not being dry-etched by a gas as described above.

US-A-4 708 766, mentioned above, discloses gas or, alternatively, plasma etching of tin oxide (SnO₂), preferably using a hydrogen iodide gas. The tin oxide is formed on an oxide (silicon oxide) layer and masked by a layer of etch resistant material, such as polysilicon, silicon nitride, alumina, or silicon dioxide, or combinations of these. Silicon dioxide is preferred. It is further disclosed that the gas or plasma etching attacks the masking oxide to such a minor degree that it cannot be measured. There is no mention of interfacial reacted layers between the tin oxide and the adjoining layers.

Nonetheless, the inventors have had the insight that, when etching a transparent conducting film formed on a substrate including Si element, an adequate etching rate may be maintained by carrying out an etching process consisting of two steps such that the upper layer part of a transparent conducting film (the region where an interfacial reacted layer is not formed by reaction with Si) is wet-etched by a halide etchant and thereafter the interfacial reacted layer is dry-etched with a reactive gas including a halogen element. Thereby, side etching of the transparent conducting film of the upper layer may be significantly reduced.

As a result, patterning of a transparent conducting film can be effected with highly accurate matching to the size of pattern of an etching resistant film, for example a resist pattern. Simultaneously, increase of leakage current due to irregular etching in the periphery of a light receiving region can be prevented and deterioration of characteristics arising from etching of an electrode can also be prevented.

Reference is made, by way of example, to the accompanying drawings, in which:-
Fig. 1(a) is a schematic sectional view of a sample immediately before a transparent conducting film is formed, after a multilayered film consisting of a-SiC film/a-Si film/a-SiC film has been formed as a light receiving part;
Fig. 1(b) is a schematic sectional view of a sample when a first transparent conducting film consisting of ITO has been formed on an a-SiC film;
Fig. 1(c) is a schematic sectional view of a sample when the first transparent conducting film has been pattern-etched by an aqueous solution of ferric chloride (FeCℓ₃);
Fig. 1(d) is a schematic sectional view of a sample when the a-SiC film/a-Si film/a-SiC film has been etched by nitrogen trifluoride (NF₃); the PSG film on the Aℓ wiring has been selectively etched to form apertures; and thereby a second transparent conducting film has been formed at the surface;
Fig. 1(e) is a schematic sectional view of a sample when the second transparent conducting film has been pattern-etched by an aqueous solution of FeCℓ₃;
Fig. 2(a) is a schematic sectional view of a sample, illustrating an interfacial reacted layer formed at the interface between a first transparent conducting film and an a-SiC film;
Fig. 2(b) is a schematic sectional view of a sample, illustrating that lateral etching proceeds in a region wherein ITO does not react with Si in the a-SiC film, and that an interfacial reacted layer remains unetched and is left on the a-SiC film;
Fig. 3(a) is a schematic sectional view of a sample, illustrating an interfacial reacted layer generated at the interface between the second transparent conducting film and PSG film;
Fig. 3(b) is a schematic sectional view of a sample, illustrating lateral etching of the ITO film and exposure of Aℓ wiring;
Figs. 4(a) to 4(g) are schematic sectional views for assistance in explaining an embodiment of the present invention, in which etching of a transparent conducting film is applied to a method of fabricating an imaging device:-

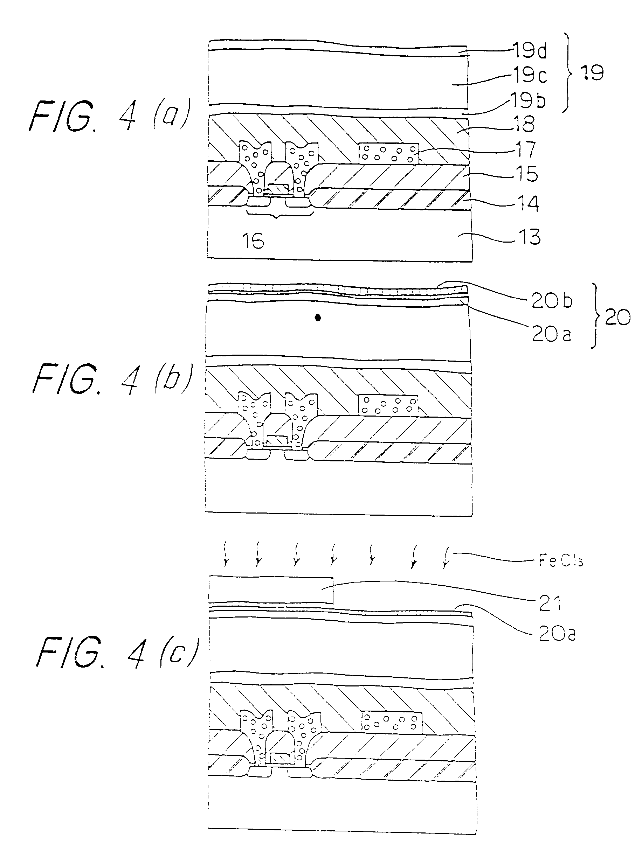

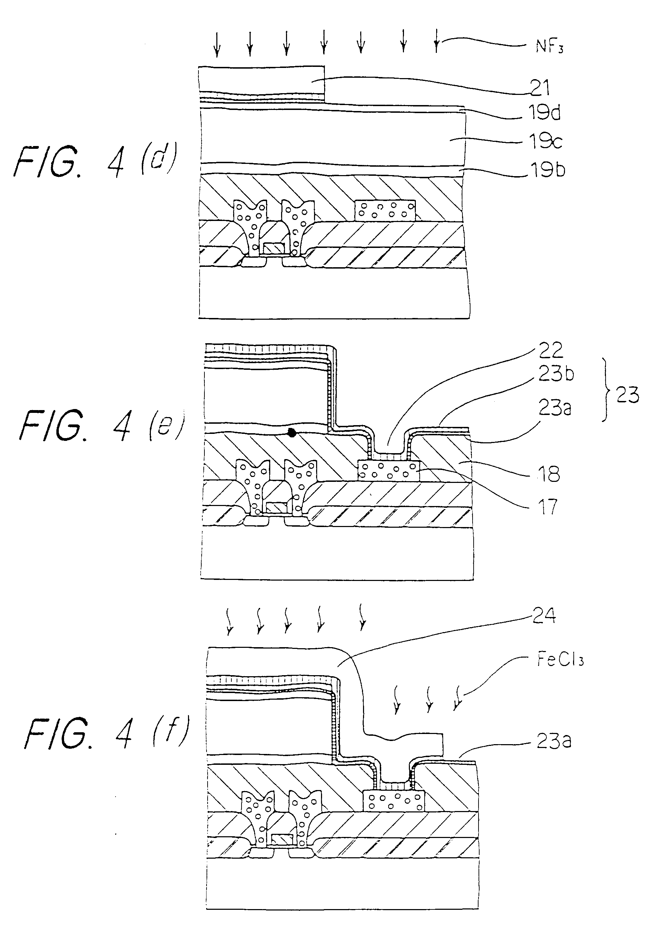

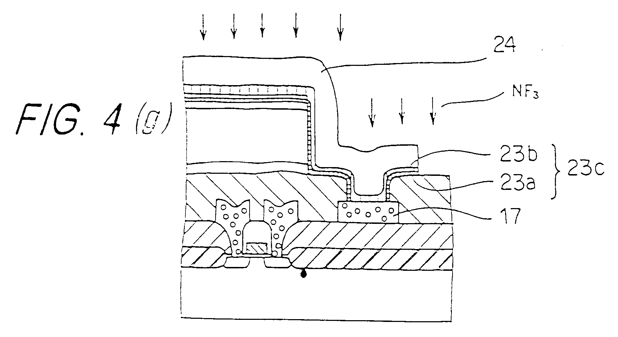

Fig. 4(a) is a schematic sectional view of a sample immediately before formation of a first transparent conducting film after a multilayered film consisting of a-SiC film/a-Si film/a-SiC film is formed as a light receiving part;
Fig. 4(b) is a schematic sectional view of a sample when the first transparent conducting film consisting of ITO film has been formed on the a-SiC film by a sputtering method;
Fig. 4(c) is a schematic sectional view of a sample when the ITO film has been pattern-etched by a 35% aqueous solution of ferric chloride (FeCℓ₃);
Fig. 4(d) is a schematic sectional view of a sample when an interfacial reacted layer has been pattern-etched by a plasma etching method using nitrogen trifluoride (NF₃);
Fig. 4(e) is a schematic sectional view of a sample when the a-SiC film/a-Si film/a-SiC film is etched, PSG film on Aℓ wiring is selectively etched to form an aperture, and thereafter a second transparent conducting film, consisting of ITO film, is formed by a sputtering method;
Fig. 4(f) is a schematic sectional view of a sample when ITO film is pattern-etched by 35% aqueous solution of ferric chloride (FeCℓ₃);
Fig. 4(g) is a schematic sectional view of a sample when an interfacial reacted layer is etched by a plasma etching method using NF₃ and thereby leadout electrodes are formed;

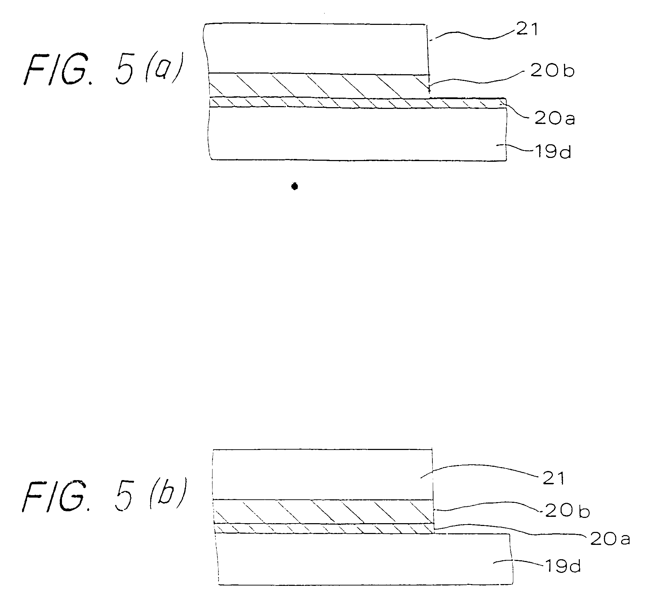

Fig. 5(a) is a schematic sectional view of a sample, showing an ITO layer etched by 35% aqueous solution of ferric chloride (FeCℓ₃) and an interfacial reacted layer remaining almost unetched;
Fig. 5(b) is a schematic sectional view of a sample indicating a condition in which an amount of side etching of ITO film is remarkably reduced even after an interfacial reacted layer is etched by NF₃;

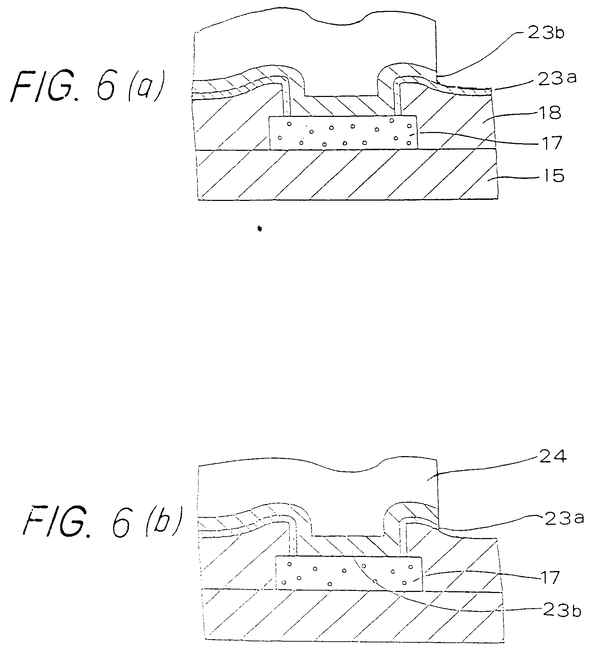

Fig. 6(a) is a schematic sectional view of a sample indicating a condition in which an ITO film formed on the PSG film is pattern-etched by 35% aqueous solution of ferric chloride (FeCℓ₃) and an interfacial reacted layer remains almost unetched;
Fig. 6(b) is a schematic sectional view of a sample indicating a condition in which an amount of side etching of ITO film is remarkably reduced even after an interfacial reacted layer is etched by NF₃; and

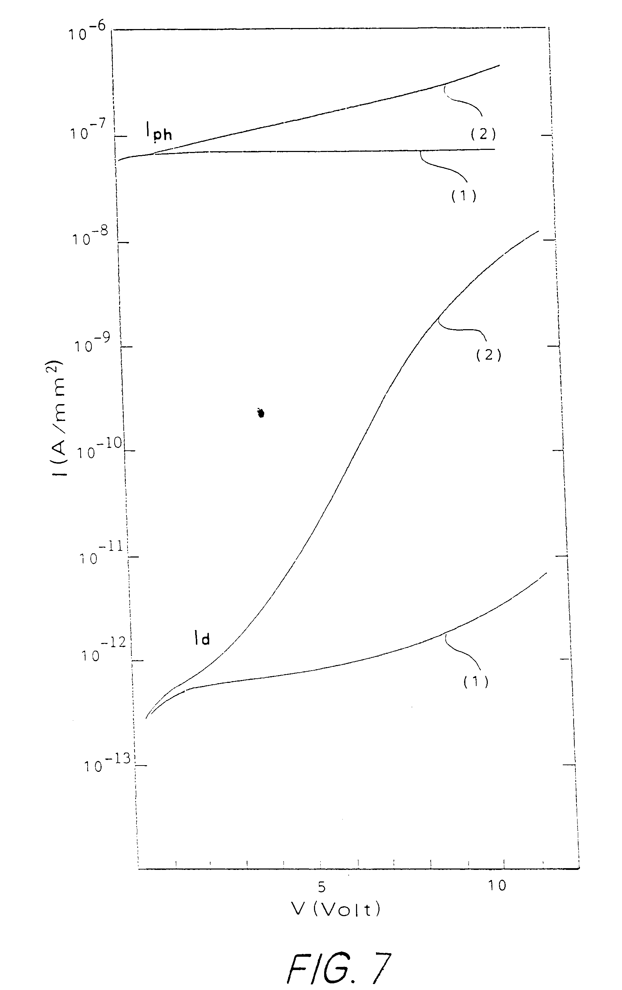

Fig. 7 is a graph indicating current - voltage characteristics of photo current and dark current of an a-Si photodiode produced using a method embodying the present invention.

An exemplary embodiment of the present invention is explained with reference to Figs. 4 to 7.

A condition immediately before a transparent conducting film is formed, after a multilayered film consisting of the a-SiC film/a-Si film/a-SiC film has been formed as a light receiving part, is indicated in Fig. 4(a).

In Fig. 4(a), 13 is a Si substrate; 14 is a SiO₂ film for device separation; 15 is an interlayer insulation film; 16 is a transistor for amplification; 17 is Aℓ wiring, 18 is a PSG film for flattening (planarization); 19 is a light receiving region consisting of a-SiC film/a-Si film/a-SiC film. A collector electrode for charges generated through photoelectric conversion, a diode for charge storage and a CCD for charge transfer are not illustrated.

As illustrated by Fig. 4(b), a sample as shown in the Figure is placed into sputtering apparatus and is kept at a temperature of about 150°C and, during this period, a first transparent conducting film consisting of ITO film is formed on a-SiC film 19d by the sputtering method. In this case, an interfacial reacted layer 20a of Si and ITO is formed at the interface between the a-SiC film 19d and the first transparent conducting film 20, and a part 20b of the ITO where an interfacial reacted layer does not exist is left as an upper layer.

As shown in Fig. 4(c), a resist pattern 21 is formed on the ITO film 20b and the ITO film 20b is etched, first at 30°C to 60°C by an aqueous solution of ferric chloride (FeCℓ₃) with the resist pattern 21 used as the mask. A preferable temperature is 40°C. Moreover, the concentration of the aqueous solution should be in the range 30% to 40%, and a preferable concentration is 35%. In this case, etching rate is 200 to 1000 Å/min. As etchant, hydrochloric acid (HCℓ), a mixed acid of hydrochloric acid and nitric acid (HNO₃), hydroiodic acid (HI) and hydrobromic acid (HBr) may also be used, in addition to the ferric chloride aqueous solution.

Thereafter, as shown in Fig. 4(d), the interfacial reacted layer 20a is etched by a plasma etching method using nitrogen trifluoride (NF₃) gas. Exemplary conditions for this plasma etching are as follows. NF₃ at 150 SCCM is supplied to the plasma etching chamber and the pressure is kept at 0.3 to 1.0 Torr (1 Torr = 133 Pa). (The preferable pressure is 0.6 Torr). The sample is kept at 60°C. The plasma generating frequency is 13.56 MHz and the power is in the range from 0.05 W/cm² to 0.3 W/cm². Under these conditions, etching rate for a-Si is set to 2000 Å/min.

As shown in Fig. 5(a), the interfacial reacted layer 20a remains almost unetched after etching with 35% aqueous solution of the ferric chloride (FeCℓ₃) and therefore here the etching process is switched to plasma etching. The Si element included in the interfacial reacted layer 20a is etched because it reacts with NF₃ to generate silicon tetrafluoride (SiF₄). Therefore, this plasma etching provides an adequate etching rate. Accordingly, the extent of side etching of ITO film 20b can be reduced remarkably as shown in Fig. 5(b).

Therefore, the first transparent conducting film 20 can be patterned with a high accuracy in accordance with the resist pattern 21. Moreover, since the light receiving part 19 under the resist pattern 21 is always covered with the ITO film 20b, deterioration of the heterojunction at the light receiving part can be prevented.

Thereafter, as shown in Fig. 4(e), the a-SiC film 19d/a-Si film 19c/a-SiC film 19b are etched under similar conditions, and the PSG film 18 on the Aℓ wiring 17 is selectively etched to form the aperture 22. The sample is then put into the sputtering apparatus, kept at 150°C, and second transparent conducting film 23 consisting of ITO film is formed by the sputtering method. Thereby, the Aℓ wiring 17 and the second transparent conducting film 23 are connected through the aperture 22.

In this process, like the process of Fig. 4(b), an interfacial reacted layer 23a produced by reaction of Si element included in the PSG film 18 and ITO is formed at the interface of the PSG film 18 and the second transparent conducting film 23. An ITO film 23b, other than the interfacial reacted layer 23a, remains as an upper layer of second transparent conducting film 23 which has not generated an interfacial reacted layer by reaction.

Next, as shown in Fig. 4(f), after the resist pattern 24 is formed on the second transparent conducting film 23, the ITO film 23b is etched by aqueous solution of ferric chloride (FeCℓ₃) with resist pattern 24 used as the mask. As shown in Fig. 6(a), interfacial reacted layer 23a is not easily etched by the aqueous solution and remains in place.

Thereafter, as shown in Fig. 4(g), the interfacial reacted layer 23a is etched by the plasma etching method using NF₃, to form a leadout electrode 23c. Also, in this case, the interfacial reacted layer 23a includes Si element, and NF₃ has an adequate etching rate for the interfacial reacted layer 23a. As shown in Fig. 6(b), the interfacial reacted layer 23a and ITO film 23b are patterned with high accuracy depending on the resist pattern 24 and the Aℓ wiring 17 as the lower layer is not etched, unlike the situation shown in Fig. 3(b).

Finally, the resist pattern is removed to complete an imaging device.

Fig. 7 shows respective current - voltage characteristics of photo current (I_{Ph}) and dark current (I_{d}) of an a-Si photo diode fabricated using an embodiment of the present invention. In Fig. 7, current - voltage characteristics of photo current (I_{Ph}) and dark current (I_{d}) of an a-Si photo diode fabricated using the conventional etching method are shown for the purpose of comparison. In this Figure, curves (1) relate to current -voltage characteristics of the a-Si photo diode fabricated using an etching method in accordance with an embodiment of the present invention, whilst curves (2) relate to the current - voltage characteristics of a similar a-Si photo diode fabricated using the conventional etching method. As is clear from this Figure, I_{d} and I_{Ph} of the a-Si photo diode fabricated using the etching method of an embodiment of the present invention show little change in the voltage range from 0 to 10 volts. This means that the etching method of the present invention does not in essence cause any increase of leakage current.

In the described embodiment, NF₃ was used as the gas for plasma etching the interfacial reacted layer of ITO and Si, but the following gases can also be used, providing an effect similar to NF₃. When such gases are used, the other conditions may be the same as those for NF₃ or may be somewhat changed, as required. The gases are:-
fluorine (F₂), nitrogen trifluoride (NF₃), tetrafluoromethane (CF₄), hexafluoroethane(C ₂F ₆) , octafluoropropane (C₃F₈), hydrogen fluoride (HF), chlorine (Cℓ₂), tetrachloromethane (CCℓ₄), hydrogen chloride (HCℓ), dichlorosilane (SiH₂Cℓ₂), tetrachloro-difluoroethane (C₂F₂Cℓ₄), trifluoromethane (CHF₃), bromine (Br₂), hydrogen bromide (HBr).

In the described embodiment a silicon (Si) substrate was referred to. However, embodiments of the present invention can be applied when other substrate materials are used, for example:-
silicon, silicon carbide (SiC), silicon-germanium(SiGe),spin-on-glass (SOG), phosphosilicate glass (PSG), silicon dioxide (SiO₂), borophosphosilicate glass (BPSG).

Alternatives to ITO film which may be used in embodiments of the present invention are, for example, indium oxide and zinc oxide film. Mixtures of such materials may be used.

Alternatives to an aqueous solution of ferric chloride, as etchant, which may be used in embodiments of the present invention are hydrochloric acid, hydroiodic acid, hydrobromic acid, and a mixed acid of hydrochloric acid and nitric acid for example.

An embodiment of the present invention provides a method of forming a pattern of a transparent conducting film such as ITO film formed on the surface of a substrate including Si, being heated, by employing a two-step etching method, in which such transparent conducting film is wet-etched by an aqueous solution of halide and thereafter an interfacial reacted layer generated at the interface of the transparent conducting film and substrate including Si is etched by a plasma etching method using halogen element.

## Claims

1. A method of forming a patterned transparent conducting film during fabrication of a semiconductor device, comprising the steps of:-
heating a substrate to a temperature of more than 100°C, the substrate including silicon atoms;
forming, whilst maintaining the temperature of the substrate greater than 100°C, a transparent conducting film which includes at least one of indium tin oxide (ITO), aluminium zinc oxide (AZO), tin oxide (SnO₂) indium oxide (In₂O₃), and zinc oxide (ZnO) on the substrate;
patterning a resist film after forming said resist film on said transparent conducting film; and
wet-etching said transparent conducting film using an etchant including a halide, using the patterned resist film as mask, and then dry-etching said transparent conducting film with a reactive gas including a halogen element.

2. A method as claimed in claim 1, wherein said substrate is formed of any one of silicon (Si), silicon carbide (SiC), silicon-germanium (SiGe), spin-on-glass (SOG), phosphosilicate glass (PSG), silicon dioxide (SiO₂), boro-phosphosilicate glass (BPSG).

3. A method as claimed in claim 1 or 2, wherein the etchant including a halide is any one of an aqueous solution of ferric chloride (FeCℓ₃), hydrochloric acid (HCℓ), hydroiodic acid (HI), hydrobromic acid (HBr), a mixed acid of hydrochloric acid and nitric acid.

4. A method as claimed in claim 3, wherein the etchant including halide is a solution of ferric chloride (FeCℓ₃) and the etching is carried out at a temperature of 30 to 60°C with a 30 to 40% aqueous solution.

5. A method a claimed in claim 1, 2, 3 or 4, wherein the reactive gas including said halogen element is any one of fluorine (F₂), nitrogen trifluoride (NF₃), tetrafluoromethane (CF₄), hexafluoroethane (C₂F₆), octafluoropropane (C₃F₈), hydrogen fluoride (HF), chlorine (Cℓ₂), tetrachloromethane (CCℓ₄), hydrogen chloride (HCℓ), dichlorosilane (SiH₂Cℓ₂), tetrachloro-difluoroethane (C₂F₂Cℓ), trifluoromethane (CHF₃), bromine (Br₂), hydrogen bromide (HBr).

6. A method of forming a patterned transparent conducting film according to claim 1 or 4, wherein the reactive gas is nitrogen trifluoride (NF₃) and said dry etching is carried out by plasma etching method under the condition that the pressure is 40 - 133 Pa (0.3 to 1.0 Torr) and the power is 0.05 to 0.3 W/cm².

## Patentansprüche

1. Verfahren zur Ausbildung eines strukturierten, transparenten Leiterfilms während der Herstellung einer Halbleitervorrichtung, umfassend
das Erhitzen eines Substrats auf eine Temperatur von mehr als 100°C, wobei das Substrat Siliciumatome enthält;
das Ausbilden - unter Beibehaltung einer Substrattemperatur von mehr als 100°C - eines transparenten Leiterfilms, der auf dem Substrat mindestens ein Oxid enthält, ausgewählt aus Indium-Zinnoxid (ITO), Aluminium-Zinkoxid (AZO), Zinnoxid (SnO₂), Indiumoxid (In₂O₃) und Zinkoxid (ZnO);
das Strukturieren eines Resistfilms nach dem Ausbilden des Resistfilms auf dem transparenten Leiterfilm; und
das Naßätzen des transparenten Leiterfilms mit einem Ätzmittel, das ein Halid enthält, wobei der strukturierte Resistfilm als Maske verwendet wird, und dann das Trockenätzen des transparenten Leiterfilms mit einem Reaktivgas, das ein Halogenelement enthält.

2. Verfahren nach Anspruch 1, wobei das Substrat ausgebildet wird aus irgendeinem Silicium (Si), Siliciumcarbid (SiC), Siliciumgermanium (SiGe), Spin-On-Glas (SOG) , Phosphosilicatglas (PSG), Siliciumdioxid (SiO₂), Borphosphorsilicatglas (BPSG).

3. Verfahren nach Anspruch 1 oder 2, wobei das halidhaltige Ätzmittel irgendeines ist aus wäßriger Eisen-III-Chloridlösung (FeCl₃), Salzsäure (HCl), Jodwasserstoffsäure (HI), Bromwasserstoffsäure (HBr), einem gemischten Salz der Salzsäure und der Salpetersäure.

4. Verfahren nach Anspruch 3, wobei das halidhaltige Ätzmittel eine Lösung ist aus Eisen-III-Chlorid (FeCl₃) und das Ätzen bei einer Temperatur von 30 bis 60°C mit einer 30 bis 40%igen wäßrigen Lösung erfolgt.

5. Verfahren nach Anspruch 1, 2, 3 oder 4, wobei das Halogenelement-haltige Reaktivgas irgendeines ist aus Fluor (F₂), Stickstofftrifluorid (NF₃), Tetrafluormethan (CF₄), Hexaflurorethan (C₂F₆), Octafluorpropan (C₃F₈), Wasserstofffluorid (HF) Chlor (Cl₂), Tetrachlormethan (CCl₄), Chlorwasserstoff (HCl), Dichlorsilan (SiH₂Cl₂), Tetrachlordifluorethan (C₂F₂Cl), Trifluormethan (CHF₃), Brom (Br₂), Bromwasserstoff (HBr).

6. Verfahren zur Ausbildung eines strukturierten, transparenten Leiterfilms nach Anspruch 1 oder 4, wobei das Reaktivgas Stickstofftrifluorid (NF₃) ist, und das Trockenätzen erfolgt mit einem Plasmaätzverfahren unter den Bedingungen, daß der Druck 40 bis 133 Pa (0,3 bis 1,0 Torr) ist und die Leistung 0,05 bis 0,3 W/cm² ist.

## Revendications

1. Procédé de formation d'un film conducteur transparent conformé pendant la fabrication d'un dispositif à semiconducteur, comprenant les étapes de :
chauffage d'un substrat à une température supérieure à 100 °C, le substrat incluant des atomes de silicium ;
formation, tout en maintenant la température du substrat supérieure à 100 °C, d'un film conducteur transparent qui inclut au moins un élément pris parmi l'oxyde d'indium-étain (ITO), l'oxyde d'aluminium-zinc (AZO), l'oxyde d'étain (SnO₂), l'oxyde d'indium (In₂O₃) et l'oxyde de zinc (ZnO) sur le substrat ;
conformation d'un film de réserve après formation dudit film de réserve sur ledit film conducteur transparent ;
gravure par voie humide dudit film conducteur transparent en utilisant un agent de gravure incluant un halure, en utilisant le film de réserve conformé en tant que masque, puis gravure par voie sèche dudit film conducteur transparent à l'aide d'un gaz réactif incluant un élément halogène.

2. Procédé selon la revendication 1, dans lequel ledit substrat est formé en un élément quelconque pris parmi le silicium (Si), le carbure de silicium (SiC), le siliciumgermanium (Si-Ge), le verre appliqué par un mélange organique (SOG), le verre de phosphosilicate (PSG), le dioxyde de silicium (SiO₂), le verre de boro-phosphosilicate (BPSG)

3. Procédé selon la revendication 1 ou 2, dans lequel l'agent de gravure qui inclut un halure est un agent quelconque pris parmi une solution aqueuse de chlorure ferrique (FeCl₃), d'acide chlorhydrique (HCl), d'acide hydroiodique (Hl), d'acide hydrobromique (HBr) et d'un acide mixte constitué par de l'acide chlorhydrique et par de l'acide nitrique.

4. Procédé selon la revendication 3, dans lequel l'agent de gravure incluant un halure est une solution de chlorure ferrique (FeCl₃) et la gravure est mise en oeuvre à une température de 30 à 60 °C à l'aide d'une solution aqueuse entre 30 et 40 %.

5. Procédé selon l'une quelconque des revendications 1, 2, 3 ou 4, dans lequel le gaz réactif incluant un élément halogène est un gaz quelconque pris parmi le fluor (F₂), le trifluorure d'azote (NF₃), le tétrafluorométhane (CF₄), l'hexafluoroéthane (C₂F₆), l'octofluoropropane (C₃F₈), le fluorure d'hydrogène (HF), le chlore (Cl₂), le tétrachlorométhane (CCl₄), le chlorure d'hydrogène (HCl), le dichlorosilane (SiH₂Cl₂), le tétrachlorodifluoroéthane (C₂F₂Cl), le trifluorométhane (CHF₃), le brome (Br₂), le bromure d'hydrogène (HBr).

6. Procédé de formation d'un film conducteur transparent conformé selon la revendication 1 ou 4, dans lequel le gaz réactif est du trifluorure d'azote (NF₃) et ladite gravure par voie sèche est mise en oeuvre au moyen d'un procédé de gravure plasma moyennant pour conditions que la pression est comprise entre 40 et 133 Pa (0,3 et 1,0 Torr) et la puissance est comprise entre 0,05 et 0,3 W/cm².
